(19) Europäisches Patentamt
European Patent Office
Office européen des brevets

(11) **EP 4 685 751 A1**

(12) **EUROPEAN PATENT APPLICATION**

(43) Date of publication:
**28.01.2026 Bulletin 2026/05**

(21) Application number: **24190113.1**

(22) Date of filing: **22.07.2024**

(51) International Patent Classification (IPC):
**G06T 15/20** (2011.01)    **G06T 17/00** (2006.01)

(52) Cooperative Patent Classification (CPC):
**G06T 15/20; G06F 30/10; G06F 40/30; G06N 3/045; G06T 17/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Robert Bosch GmbH**
**70442 Stuttgart (DE)**

(72) Inventors:
- **Tatarchenko, Maxim**
  **10115 Berlin (DE)**
- **Oecal, Melis**
  **1093 DM Amsterdam (NL)**
- **Karaoglu, Sezer**
  **1087MC Amsterdam (NL)**
- **Gevers, Theo**
  **1091HR Amsterdam (NL)**

Remarks:
Amended claims in accordance with Rule 137(2) EPC.

(54) **DEVICE AND COMPUTER IMPLEMENTED METHOD FOR GENERATING A SYNTHETIC DIGITAL IMAGE OF A THREE-DIMENSIONAL SCENE**

(57)    A device and a computer implemented method for generating a synthetic digital image (800) of a three-dimensional scene, in particular for a dataset for training and/or testing of a machine learning system, wherein the method comprises providing at least one text prompt, wherein the at least one text prompt comprises a description of a three-dimensional layout of the scene, wherein the at least one text prompt comprises a description of a style of the scene, generating the layout depending on the description of the layout, assembling the scene depending on the layout, determining a three-dimensional Gaussian Splatting representation of the assembled scene depending on the assembled scene, rendering a digital image from the three-dimensional Gaussian Splatting representation, and determining the synthetic digital image (800) with a stable diffusion depending on the digital image and the description of the style.

Fig. 8

**Description**

Background

The invention concerns a device and a computer implemented method for generating a synthetic digital image of a three-dimensional scene.

Text-to-3D generation models may be used to generate synthetic digital images of three-dimensional scenes.

Disclosure of the invention

A computer implemented method for generating a synthetic digital image of a three-dimensional scene, in particular for a dataset for training and/or testing of a machine learning system, comprises providing at least one text prompt, wherein the at least one text prompt comprises a description of a three-dimensional layout of the scene, wherein the at least one text prompt comprises a description of a style of the scene, generating the layout depending on the description of the layout, assembling the scene depending on the layout, determining a three-dimensional Gaussian Splatting representation of the assembled scene depending on the assembled scene, rendering a digital image from the three-dimensional Gaussian Splatting representation, and determining the synthetic digital image with a stable diffusion depending on the digital image and the description of the style. This method is able to hallucinate complex scenes with multiple objects.

The at least one text prompt may comprise a description of a position of at least one object in the scene in a two-dimensional perspective, and in that the at least one text prompt comprises a description of an orientation of the at least one object in the scene in a two-dimensional perspective, wherein generating the layout comprises producing a three-dimensional bounding box for the at least one object in the scene depending on the description of the position and the description of the orientation. This method allows object-level control during scene generation.

Producing the bounding box for example comprises determining a box center of the bounding box depending on the description of the position and determining a box orientation of the bounding box depending on the description of the orientation.

Determining the description of the position and the description of the orientation for example comprises providing a canonical coordinate system representing the scene in a two-dimensional perspective, partitioning the canonical coordinate system into a grid comprising rectangular patches, selecting one patch of the patches and generating the textual description of the position and the orientation depending on the position of the patch in the grid. This allows the generation of per object text describing the position of the object in the scene.

Assembling the scene depending on the layout may comprise retrieving a three-dimensional model of the at least one object from a database that comprises three-dimensional models of objects, in particular retrieving the three-dimensional model that has the least Euclidean distance between the dimensions of the three-dimensional model and the bounding box dimensions of the bounding box for the at least one object, and placing the retrieved three-dimensional model of the at least one object in the scene at the box center and in the box orientation. This allows the generation objects matching the bounding box dimensions in the scene.

Determining the synthetic digital image may comprise determining the pixel values of pixels in the synthetic digital image that represent the at least one object with the stable diffusion depending on pixel values of pixels in the digital image that represent the at least one object, and setting the pixel values of pixels of the synthetic digital image not representing the at least one object to the values of the pixels of the digital image not representing the at least one object.

This allows generation of the at least one object in the synthetic digital image without changing other parts of the digital image.

The method may comprise training the three-dimensional Gaussian Splatting representation and/or the stable diffusion depending on a loss that depends on the values of the pixels representing the at least one object. This guides the gradient to propagate towards the target for the at least one object.

The method may comprise determining a binary mask indicating whether a pixel represents the at least one object or not, and determining the pixel values of pixels that that represent the at least one object according to the binary mask with the stable diffusion.

The method may comprises generating another synthetic digital image for the dataset with the stable diffusion depending on the same three-dimensional Gaussian Splatting representation. This generates different synthetic digital images due to the randomness of the stable diffusion.

The method may comprise providing another at least one text prompt, determining another three-dimensional Gaussian Splatting representation depending on the description of the three-dimensional layout of the scene in the other at least one text prompt, and determining another synthetic digital image for the dataset depending on the other Gaussian Splatting representation and the description of the style in the other at least one text prompt. This generates different synthetic digital images due to different prompts.

Tendering the digital image from the three-dimensional Gaussian Splatting representation may comprise providing a viewpoint, and rendering a view of the scene from the viewpoint.

The method may comprise providing three different viewpoints, and determining for the three viewpoints, the synthetic digital image showing the scene from the respective viewpoint. This uses three viewpoints provided by the three-dimensional Gaussian Splatting.

A device for generating a synthetic digital image of a three-dimensional scene, in particular for a dataset for training and/or testing of a machine learning system, comprises at least one processor and at least one memory that stores instructions, wherein the at least one processor is configured to execute the instruction that, when executed by the at least processor, cause the device to execute the method.

A computer program for generating a synthetic digital image of a three-dimensional scene, in particular for a dataset for training and/or testing of a machine learning system comprises computer executable instructions that, when executed by the computer, cause the computer to execute the method.

Further embodiments are derived from the following description and the drawing. In the drawing:

Fig. 1 schematically depicts a device for generating a synthetic digital image of a three-dimensional scene, in particular for a dataset for training and/or testing of a machine learning system,

Fig. 2 schematically depicts an exemplary three-dimensional layout,

Fig. 3 schematically depicts an exemplary three-dimensional scene assembled depending on the three-dimensional layout,

Fig. 4 schematically depicts an exemplary three-dimensional Gaussian Splatting representation of the exemplary assembled scene,

Fig. 5 schematically depicts a first exemplary digital image comprising a view from a first viewpoint rendered from the exemplary three-dimensional Gaussian Splatting representation,

Fig. 6 schematically depicts a second exemplary digital image comprising a view from a second viewpoint rendered from the exemplary three-dimensional Gaussian Splatting representation,

Fig. 7 schematically depicts a third exemplary digital image comprising a view from a third viewpoint rendered from the exemplary three-dimensional Gaussian Splatting representation,

Fig. 8 schematically depicts a first exemplary synthetic digital image comprising the view from the first viewpoint determined by a stable diffusion from the first exemplary digital image and a description of a style,

Fig. 9 schematically depicts a second exemplary synthetic digital image comprising the view from the second viewpoint determined by the stable diffusion from the second exemplary digital image and the description of the style,

Fig. 10 schematically depicts a third exemplary synthetic digital image comprising the view from the third viewpoint determined by the stable diffusion from the third exemplary digital image and the description of the style,

Fig. 11 schematically depicts the three-dimensional scene.

Fig. 12 depicts a flowchart comprising steps of a method for generating the synthetic digital image of the three-dimensional scene, in particular for the dataset for training and/or testing of the machine learning system.

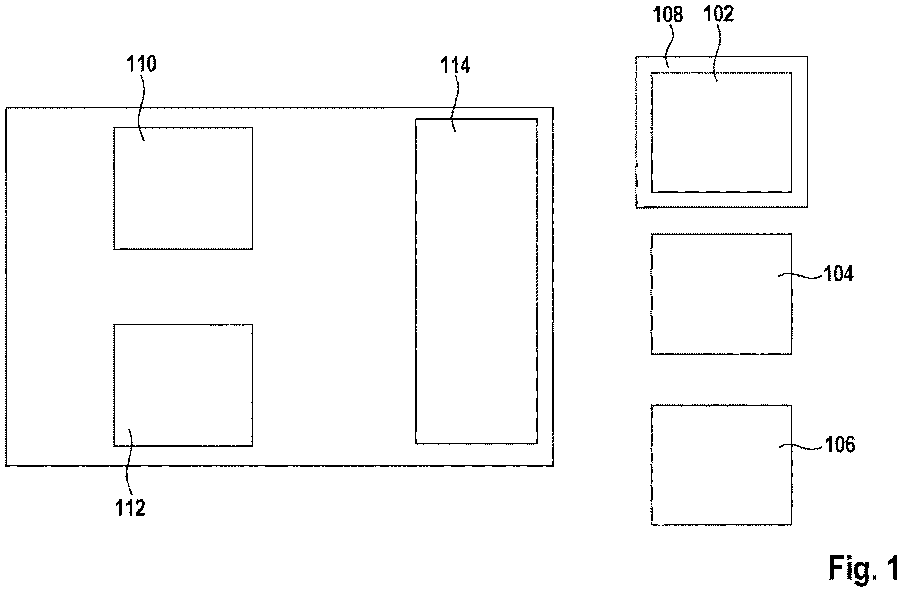

Figure 1 schematically depicts a device 100 for generating a synthetic digital image 102 of a three-dimensional scene 104 depending on at least one text prompt 106.

The device 100 may be configured for generating the synthetic digital image 102 for a dataset 108 for training and/or testing of a machine learning system.

The device 100 comprises at least one processor 110 and at least one memory 112. The at least one memory 112 is configured to store the synthetic digital image 102 and instructions for generating the synthetic digital image 102.

The device 100 may comprise an interface 114. The interface 114 is configured to receive the at least one text prompt 106. The interface 114 may be configured to output the synthetic digital image 102 and/or the three-dimensional scene 104.

The at least one text prompt 106 comprises a textual description Y of a three-dimensional layout of the scene. The at least one text prompt comprises a description of a style of the scene.

The description Y may comprise one sentence or more sentences. A sentence in the description Y specifies a position and/or an orientation of an object in the scene.

An exemplary description of an exemplary three-dimensional layout of an exemplary scene is:

"A double bed is positioned in the middle of the room, a bit nearer to the tip left wall, set a ta right angle. In close proximity of the top left corner, a nightstand is situated set at a right angle. Another nightstand can be found placed near the bottom left corner, also set at a right angel. In the bottom left corner, a wardrobe is positioned, with no particular orientation. Lastly, a shelf is set in the top right corner, with no rotation."

An example for the description of an exemplary style of the scene is:

"Make it Pirates of the Caribbean style".

The device 100 is configured for generating the three-dimensional layout of the scene depending the description of the three-dimensional layout of the scene.

The device 100 is configured for assembling the scene depending on the three-dimensional layout of the scene.

The device 100 is configured for determining a three-dimensional Gaussian Splatting representation of the assembled scene depending on the assembled scene.

The device 100 is configured for rendering a digital image from the three-dimensional Gaussian Splatting representation.

The device 100 is configured for determining the synthetic digital image 102 with a stable diffusion depending on the digital image and the description of the style.

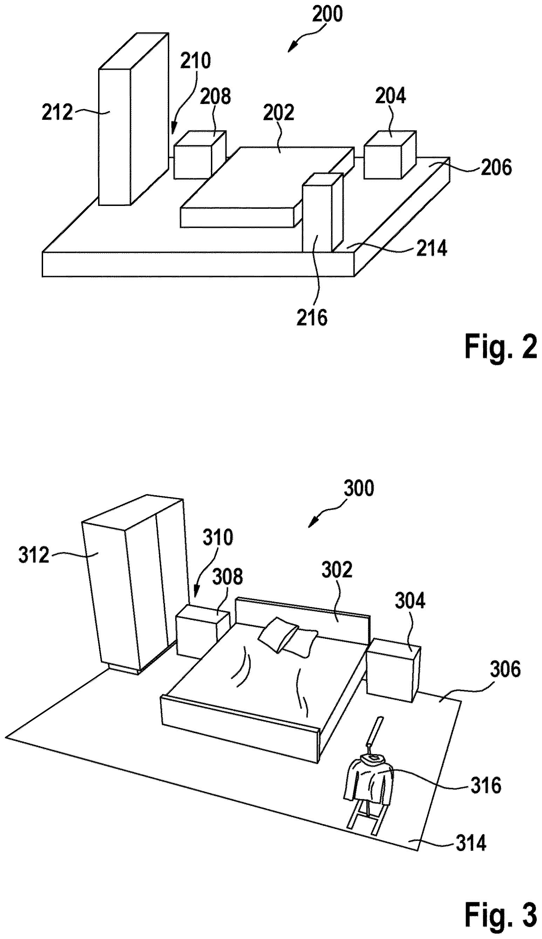

Figure 2 schematically depicts the exemplary three-dimensional layout 200.

The exemplary three-dimensional layout 200 comprises a bounding box 202 for the double bed positioned in the middle of the layout 200.

The exemplary three-dimensional layout 200 comprises a bounding box 204 for the nightstand in the top left corner 206 of the layout 200 situated set at a right angle.

The exemplary three-dimensional layout 200 comprises a bounding box 208 for the other nightstand placed near the bottom left corner 210 of the layout 200 also set at a right angel.

The exemplary three-dimensional layout 200 comprises, in the bottom left corner 210, a bounding box 212 for the wardrobe, with no particular orientation.

The exemplary three-dimensional layout 200 comprises in the top right corner 214 of the layout 200, a bounding box 216 for the shelf with no particular rotation.

Figure 3 schematically depicts an exemplary three-dimensional scene 300 assembled depending on the three-dimensional layout 200.

The exemplary three-dimensional scene 300 comprises three-dimensional model 302 for the double bed positioned in the middle of the scene 300.

The exemplary three-dimensional scene 300 comprises a three-dimensional model 304 for the nightstand in the top left corner 306 of the scene 300 situated set at a right angle.

The exemplary three-dimensional scene 300 comprises a three-dimensional model 308 for the other nightstand placed near the bottom left corner 310 of the scene 300 also set at a right angel.

The exemplary three-dimensional scene 300 comprises, in the bottom left corner 310, a three-dimensional model 312 for the wardrobe, with no particular orientation.

The exemplary three-dimensional scene 300 comprises in the top right corner 314 of the scene 300, a three-dimensional model 316 for the shelf with no particular rotation.

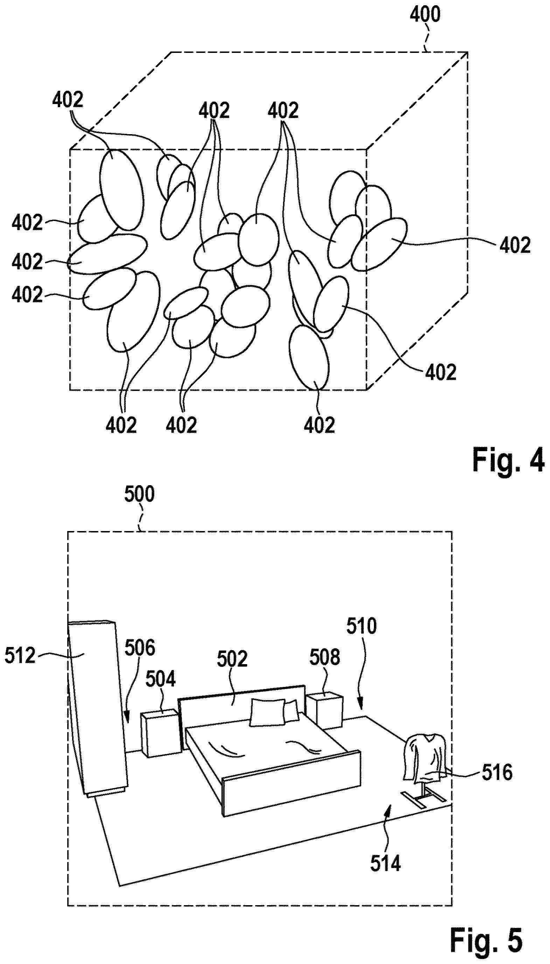

Figure 4 schematically depicts an exemplary three-dimensional (3D) Gaussian Splatting representation 400 of the exemplary assembled scene 300.

3D Gaussian splatting represents the underlying scene as a collection of anisotropic 3D Gaussians 402 defined by their center positions $\mu \in R^3$ and 3D covariance matrices $\Sigma$ parameterized as:

$$\Sigma = RSS^T R^T$$

wherein $R$ denotes the rotation nmatrix and $S$ is the scale matrix.

Each 3D Gaussian of the 3D Gaussian splatting is assigned a color $c$ represented with spherical harmonics (SH) coefficients, to capture the view-dependent appearance. To allow $\alpha$-blending of splats, Gaussians are associated with an opacity value $a \in R$.

3D Gaussian splatting enables faster training and rendering through differentiable rasterization.

A set of 3D Gaussians is rendered by projecting into a camera's image plane as 2D Gaussians, and assigned to individual image tiles. The color of each pixel $p$ on the image plane is then determined as follows:

$$C(p) = \sum_{i \in N} c_i \sigma_i \prod_{j=1}^{i-1} \left(1 - \sigma_j\right), \qquad \sigma_j = \alpha_i e^{-\frac{1}{2}(p-\mu_i)^T \Sigma_i^{-1}(p-\mu_i)}$$

where $N$ denotes the Gaussians in this tile, $\sigma_j$ represents the influence of the Gaussian on the image pixel and $\mu_i, \Sigma_i, c_i, \alpha_i$ are the position, the covariance, the color and the opacity of the i-th Gaussian respectively.

For optimization, a combination of $L_1$ loss, i.e. the sum of the all the absolute differences between the true value and the predicted value, and structural similarity index (SSIM) may be employed.

Figure 5 schematically depicts a first exemplary digital image 500 comprising a view of a synthetic three-dimensional scene from a first viewpoint rendered from the exemplary three-dimensional Gaussian Splatting representation 400.

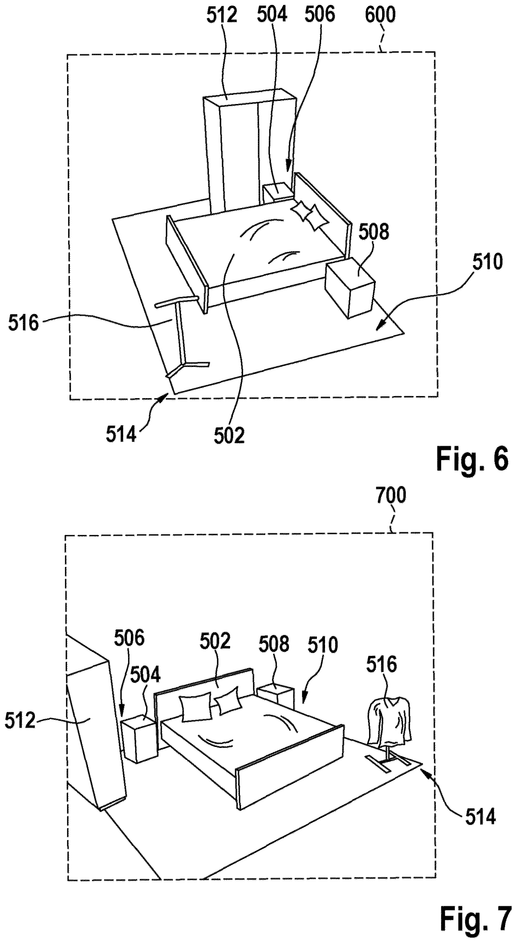

Figure 6 schematically depicts a second exemplary digital image 600 comprising a view of the synthetic three-dimensional scene from a second viewpoint rendered from the exemplary three-dimensional Gaussian Splatting representation.

Figure 7 schematically depicts a third exemplary digital image 700 comprising a view of the synthetic three-dimensional scene from a third viewpoint rendered from the exemplary three-dimensional Gaussian Splatting representation.

The exemplary digital images depict the double bed 502 positioned in the middle of the respective digital image.

The exemplary digital images depict the nightstand 504 in the top left corner 506 of the scene 300 situated set at a right angle.

The exemplary digital images depict the other nightstand 508 placed near the bottom left corner 510 of the respective exemplary digital image also set at a right angel.

The exemplary digital images depict, in the bottom left corner 510, the wardrobe 512, with no particular orientation.

The exemplary digital images depict in the top right corner 514 of the first exemplary digital image 500, the shelf 516 with no particular rotation.

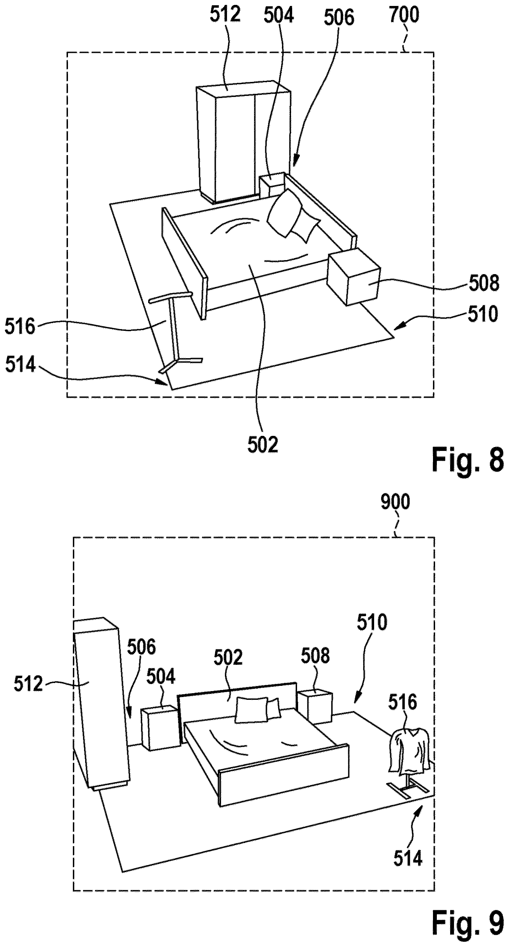

Figure 8 schematically depicts a first exemplary synthetic digital image 800 comprising the view from the first viewpoint determined by a stable diffusion from the first exemplary digital image 500 and the exemplary description of the style.

Figure 9 schematically depicts a second exemplary synthetic digital image 900 comprising the view from the second viewpoint determined by the stable diffusion from the second exemplary digital image 600 and the exemplary description of the style.

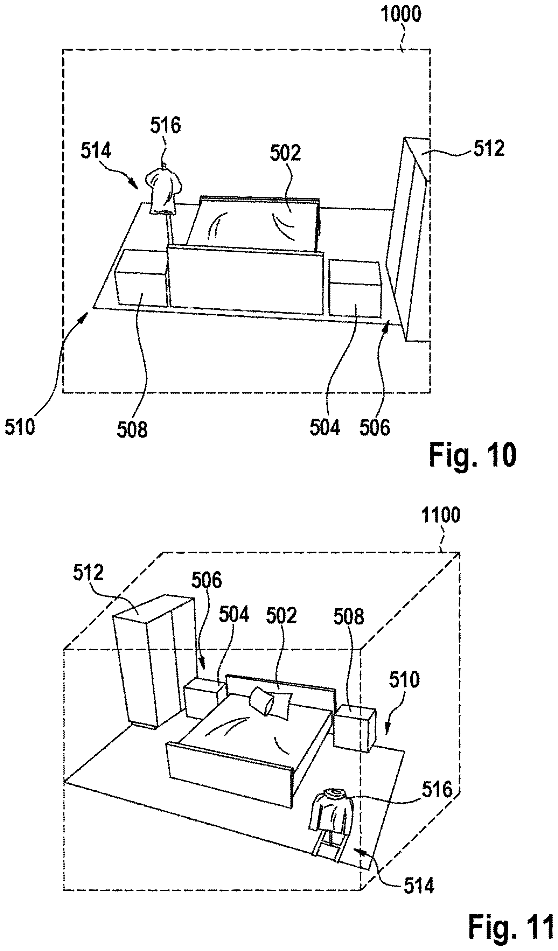

Figure 10 schematically depicts a third exemplary synthetic digital image 1000 comprising the view from the third viewpoint determined by the stable diffusion from the third exemplary digital image 700 and the exemplary description of the style.

The exemplary synthetic digital images depict the double bed 502 positioned in the middle of the respective exemplary digital image.

The exemplary synthetic digital images depict the nightstand 504 in the top left corner 506 of the respective exemplary digital image situated set at a right angle.

The exemplary synthetic digital images depict the other nightstand 508 placed near the bottom left corner 510 of the respective exemplary digital image also set at a right angel.

The exemplary synthetic digital images depict, in the bottom left corner 510 of the respective exemplary digital image , the wardrobe 512, with no particular orientation.

The exemplary synthetic digital images depict in the top right corner 514 of the first exemplary synthetic digital image 500, the shelf 516 with no particular rotation.

Figure 11 schematically depicts the exemplary synthetic three-dimensional scene 1100 that the exemplary synthetic digital images depict from the different viewpoints.

The exemplary synthetic three-dimensional scene 1100 comprises the double bed 502 positioned in the middle of the exemplary synthetic three-dimensional scene 1100.

The exemplary synthetic three-dimensional scene 1100 comprises the nightstand 504 in the top left corner 506 of the exemplary synthetic three-dimensional scene 1100 situated set at a right angle.

The exemplary synthetic three-dimensional scene 1100 comprises the other nightstand 508 placed near the bottom left corner 510 of the exemplary synthetic three-dimensional scene 1100also set at a right angel.

The exemplary synthetic three-dimensional scene 1100 comprises, in the bottom left corner 510 of the exemplary synthetic three-dimensional scene 1100, the wardrobe 512, with no particular orientation.

The exemplary synthetic three-dimensional scene 1100 comprises in the top right corner 514 of the exemplary synthetic three-dimensional scene 1100, the shelf 516 with no particular rotation.

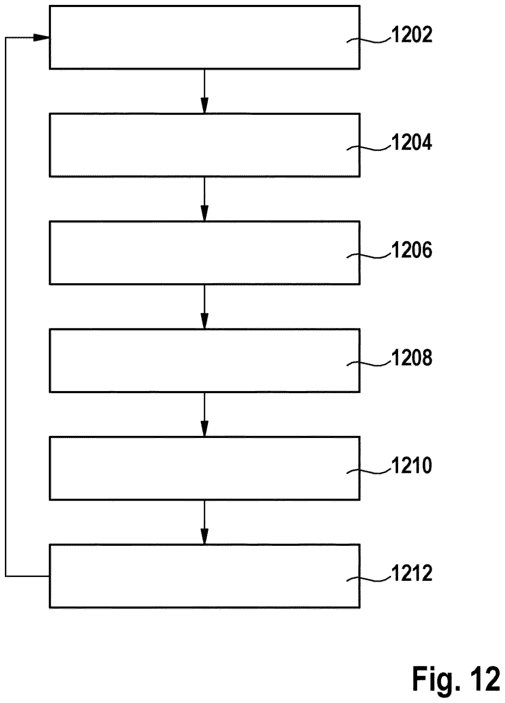

Figure 12 depicts a flowchart comprising steps of a method for generating a synthetic digital image of a three-dimensional scene.

The synthetic digital image is for example one of the exemplary synthetic digital images.

The method comprises a step 1202.

The step 1202 comprises providing at least one text prompt.

The at least one text prompt comprises the description of a layout of the three-dimensional scene.

The description of the layout for example comprises a description of a position of at least one object in the scene in a two-dimensional perspective.

The description of the layout for example comprises a description of an orientation of the at least one object in the scene in a two-dimensional perspective.

The step 1202 for example comprises providing the at least one text prompt 106 comprising the exemplary description of the exemplary three-dimensional layout 200 and the exemplary description of the exemplary style.

The exemplary description of the layout comprises a description of a position of the objects 502, 504, 508, 512, 514 in the scene 300, 1100 in the two-dimensional perspective.

The exemplary description comprises a description of an orientation of the objects 502, 504, 508, 512, 514 in the exemplary scenes 300, 1100 in the two-dimensional perspective.

The description of the position and the description of the orientation may be determined.

Determining the description of the position and the orientation may comprise providing a canonical coordinate system representing the scene in a two-dimensional perspective.

Determining the description of the position and the orientation may comprise partitioning the canonical coordinate system into a grid comprising rectangular patches.

Determining the description of the position and the orientation may comprise selecting one patch of the patches and generating the textual description Y of the position and the orientation depending on the position of the patch in the grid.

An exemplary description of the position and the orientation of an object i identified by a category name $c_i$ is: "A $c_i$ is placed at the top-left corner of the room, with a perpendicular orientation".

The description of the position and the orientation may be determined rule based. The description of the position and the orientation may be determined with a large language model, e.g., LayoutGPT (arXiv:2305.15393). New descriptions of the position and/or the orientation may be determined from a given description of the position and the orientation by prompting the large language model to paraphrase the given description.

The method comprises a step 1204.

The step 1204 comprises generating the layout depending on the description of the layout. The step 1204 for example comprises generating the exemplary layout 200 depending on the exemplary description of the exemplary layout 200.

The layout comprises the at least one object in the position and the orientation according to the description of the layout.

Generating the layout for example comprises producing a three-dimensional bounding box for the at least one object in the scene depending on the description of the position and the description of the orientation.

Producing a bounding box $b_i$ for example comprises determining a box center $t_i = (x_i, y_i, z_i) \in \mathbb{R}^3$, box dimensions $s_i = (w_i, h_i, d_i) \in \mathbb{R}^3$, and a box orientation $o_i \in \mathbb{R}$ of the bounding box $b_i$ depending on the depending on the textual description Y. The bounding box $b_i$ may be associated with a category name $c_i$ that identifies the object that the bounding box represents. The box orientation $o_i$ is for example an orientation angle.

For a plurality of N objects, the bounding boxes $b_i \in B = \{b_i\}_{i=1}^{N}$ may be determined.

The method is not limited to the box center, box dimensions, and box orientation as bounding box values. The method may use other representations of bounding box values as well.

The bounding box values may be mapped to standard CSS format attributes and category name $c_i$ of a respective bounding box may be employed as the selector for the respective bounding box.

The bounding box $b_i$ may be produced by prompting a large language model with a prompt to produce the bounding box $b_i$.

Prompt Construction:

The large language model may be provided with a prompt comprising the given description of the position and the orientation, and given bounding box values, and an explanation that the large language model shall provide the given bounding box values for the given description of the position and the orientation.

The large language model may be provided with a prompt comprising a further description of the position and the orientation and the task to output further bounding box values for the further description.

Exemplary prompts to the large language model include the three parts: task specifications, in-context exemplars and the query condition.

Task specifications:

A task description is incorporated at the beginning of a respective prompt. The task description explains the goal of the task, establishes a standard for the 3D layout format in CSS style and provides unit information for the bounding box values.

The task description may comprise constraints to guide the large language model and minimize errors during task completion. Exemplary constraints comprise constraints on the bounding box values that exclude predicting overlapping boxes or bounds on the bounding box values that exclude placing bounding boxes out of the bounds. The bounds may be the bound of the scene.

In-context learning:

Supporting exemplars for the in-context learning are selected by adopting the retrieval-based approach used in LayoutGPT. When provided with a set of supporting exemplars

$$S = \{(\mathcal{C}_m^s, b_m^s)\}_{m=1}^M$$

and the queried condition $\mathcal{C}_q$, the function

$$f(\mathcal{C}_k^s, \mathcal{C}_q) = \left| rl_k - rl_q \right|^2 + \left| rw_k - rw_q \right|^2$$

is computed between each element of the set and $\mathcal{C}_q$ following LayoutGPT, where *rl* and *rw* are the length and width of the scenes. Top-k supporting exemplars with the shortest distance to $\mathcal{C}_q$ are selected for in-context learning, provided to the large language model with the same format with $\mathcal{C}_q$.

Query condition:

The inference condition $\mathcal{C}_q$, for which the large language model shall predict the layout.

For example the exemplary three-dimensional layout 200 is generated depending on the description of the exemplary layout 200.

For example, the three-dimensional bounding boxes 202, 204, 208, 212, 214 are generated for the objects 502, 504, 508, 512, 514 in the scene 300, 1100 depending on the exemplary description of the position and the exemplary description of the orientation.

Producing the bounding box for example comprises determining the box centers, box dimensions, and box orientations for the bounding boxes 202, 204, 208, 212, 214 depending on the exemplary description of the scene.

The method comprises a step 1206.

The step 1206 comprises assembling the scene depending on the layout.

For example, the exemplary scene 300 is assembled depending on the exemplary layout 200.

Assembling the scene depending on the layout for example comprises retrieving a three-dimensional model of the at least one object from a database that comprises three-dimensional models of objects.

For example, the three-dimensional model that has the least Euclidean distance between the dimensions of the three-dimensional model and the bounding box dimensions of the bounding box for the at least one object is retrieved.

Assembling the scene for example comprises placing the retrieved three-dimensional model of the at least one object *i* in the scene at the box center $c_i$ and in the box orientation $o_i$.

For example, three-dimensional models of the objects 502, 504, 508, 512, 514 are retrieved from the database for assembling the exemplary scene 300.

For example, the three-dimensional models of the objects 502, 504, 508, 512, 514 are retrieved that have the least Euclidean distance between the dimensions of the respective three-dimensional model and the bounding box dimensions of the respective bounding box 202, 204, 208, 212, 214 for the objects 502, 504, 508, 512, 514.

Assembling the scene 300 for example comprises placing the retrieved three-dimensional models of the objects 502, 504, 508, 512, 514 in the scene 300 at the respective box center and in the respective box orientation.

The method comprises a step 1208.

The step 1208 comprises determining a three-dimensional Gaussian Splatting representation of the assembled scene depending on the assembled scene.

For example, the exemplary three-dimensional Gaussian Splatting representation 400 of the exemplary assembled scene 300 is determined depending on the exemplary assembled scene 300.

The method comprises a step 1210.

The step 1210 comprises rendering a digital image from the three-dimensional Gaussian Splatting representation.

For example, the exemplary first digital image 500 is rendered from the exemplary three-dimensional Gaussian Splatting representation 400.

Rendering the digital image from the three-dimensional Gaussian Splatting representation may comprise providing a viewpoint, and rendering a view of the scene from the viewpoint.

For example, rendering the first exemplary digital image 500 from the exemplary three-dimensional Gaussian Splatting representation 400 comprises providing a first viewpoint, and rendering a first view of the scene 300 from the first viewpoint.

The first exemplary digital image 500 comprises the first view of the scene 300.

The method comprises a step 1212.

The step 1212 comprises determining the synthetic digital image with the stable diffusion depending on the digital image and the description of the style.

Determining the synthetic digital image for example comprises determining the pixel values of pixels in the synthetic digital image that represent the at least one object with the stable diffusion depending on pixel values of pixels in the digital image that represent the at least one object.

Determining the synthetic digital image for example comprises setting the pixel values of pixels of the synthetic digital image not representing the at least one object to the values of the pixels of the digital image not representing the at least one object.

For example, the exemplary first synthetic digital image 800 is determined with the stable diffusion depending on the exemplary first digital image 500 and the exemplary description of the style.

The exemplary first digital image 500 is an unedited conditioning image for the stable diffusion for determining the exemplary first synthetic image 800. This means the first view of the scene 300 is the initial first view of the scene 1100.

Determining the exemplary first synthetic digital image 800 for example comprises determining the pixel values of pixels in the exemplary first synthetic digital image 800 that represent the objects 502, 504, 508, 512, 514 with the stable diffusion depending on pixel values of pixels in the exemplary first digital image 500 that represent the objects 502, 504, 508, 512, 514.

Determining the exemplary first synthetic digital image 800 for example comprises setting the pixel values of pixels of the exemplary first synthetic digital image 800 not representing the one of the objects 502, 504, 508, 512, 514 to the values of the corresponding pixels of the exemplary first digital image 500 not representing one of the objects 502, 504, 508, 512, 514.

The method may comprise training the three-dimensional Gaussian Splatting representation and/or the stable diffusion depending on a loss that depends on the values of the pixels representing the at least one object in the digital image and the synthetic digital image respectively .

The method may comprise training the three-dimensional Gaussian Splatting representation 400 and/or the stable diffusion depending on a loss that depends on the values of the pixels representing the objects 502, 504, 508, 512, 514 in the exemplary digital image and the exemplary synthetic digital image respectively.

An exemplary stable diffusion comprises as input an unedited conditioning image $I_0^v$ , a text instruction $c_T$ and a noisy version of a current render $I_i^v$ at an optimization step $i$, where $v$ denotes a viewpoint from which the images are captured. Formally, the process of updating a single image with the stable diffusion is defined as:

$$I_{i+1}^v \leftarrow U_\theta(I_i^v, t; I_0^v, c_T)$$

where $t$ is the noise level within a constant range $[t_{min}, t_{max}]$, $U_\theta$ is a sampling process of a Denoising Diffusion Implicit Model, DDIM, (arXiv:2010.02502), and $I_{i+1}^v$ is the edited image respecting the text instruction $c_T$ and the unedited conditioning image $I_0^v$ . In the example, the text instruction $c_T$ is the description of the style.

The stable diffusion is trained by editing training images from the dataset to determine new images for the dataset in an update of the dataset. The dataset update is for example performed at every 2500 training iterations.

The method may comprise determining a segmentation mask $\mathcal{M}$ indicating whether a pixel represents an object or not. The segmentation mask $\mathcal{M}$ is for example a binary mask.

The method may comprise determining the pixel values of pixels that that represent an object according to the segmentation mask with the stable diffusion.

For example, binary masks $m\{o\}_{k=1}^{K}$ are determined, wherein a mask $m\{o\}_{k=1}^{K}$ is obtained by binarizing 2D segmentation masks $\mathcal{M}$ for the set of objects to edit the objects $\{o\}_{k=1}^{K}$. The set $\{o\}_{k=1}^{K}$ is defined by extracting the referenced category names $c_i$ from the text instruction $c_T$. Having the unedited conditioning image $I_0^v$ the edited image $I_{i+1}^v$, and the binary mask $m\{o\}_{k=1}^{K}$,.

This means, the method keeps only the edits at the pixels of the target object set:

$$I_{i+1}^v \leftarrow m\{o\}_{k=1}^K \odot I_{i+1}^v + \left(1 + m\{o\}_{k=1}^K\right) \odot I_0^v$$

where $\odot$ denotes element-wise multiplication of the image pixels.

This way, the other pixels within $I_{i+1}^v$ are set to their unedited versions, enabling an object-level editing of training images.

In the training, the edited images, the mask $m\{o\}_{k=1}^{K}$ is for example also applied for the $L_1$ loss and the SSIM. This ensures gradient propagation only to the target objects.

The method is described by way of example of the first viewpoint. The method may comprise providing three different viewpoints, i.e., the first viewpoint, a second viewpoint, a third viewpoint. The method may comprise determining for the three viewpoints, the digital images showing the scene 300 from the respective viewpoint and determining the synthetic digital images 800, 900, 1000 showing the scene 1100 from the respective viewpoint.

The synthetic digital images 800, 900, 1000 are examples for the synthetic digital image 102. The scene 1100 is an example of the three-dimensional scene 104.

The steps of the method may be executed repeatedly for determining different synthetic digital image for the dataset of synthetic digital images. The dataset may be used for training and/or testing of the machine learning system.

The different synthetic digital images may be generated by repeating the step 1210 with the stable diffusion depending on the same three-dimensional Gaussian Splatting representation.

The different synthetic digital images may be generated based on different descriptions of the three-dimensional layout and/or descriptions of the style by repeating the steps of the method with different at least one first prompts.

## Claims

1. Computer implemented method for generating a synthetic digital image (800, 900, 1000) of a three-dimensional scene (1100), in particular for a dataset for training and/or testing of a machine learning system, **characterized in that** the method comprises providing (1202) at least one text prompt (106), wherein the at least one text prompt (106) comprises a description of a three-dimensional layout (200) of the scene (300, 1100), wherein the at least one text prompt (106) comprises a description of a style of the scene (1100), generating (1204) the layout (200) depending on the description of the layout, assembling (1206) the scene (300) depending on the layout (200), determining (1208) a three-dimensional Gaussian Splatting representation (400) of the assembled scene (300) depending on the assembled scene (300), rendering (1210) a digital image (500, 600, 700) from the three-dimensional Gaussian Splatting representation (400), and determining (1212) the synthetic digital image (800, 900, 1000) with a stable diffusion depending on the digital image (500, 600, 700) and the description of the style.

2. The method according to claim 1, **characterized in that** the at least one text prompt (106) comprises a description of a position of at least one object (502, 504, 508, 512, 514) in the scene (300, 1100) in a two-dimensional perspective, and **in that** the at least one text prompt (106) comprises a description of an orientation of the at least one object (502, 504, 508, 512, 514) in the scene (300, 1100) in a two-dimensional perspective, wherein generating (1204) the layout (200) comprises producing a three-dimensional bounding box (202, 204, 208, 212, 214) for the at least one object (502, 504, 508, 512, 514) in the scene (300, 1100) depending on the description of the position and the description of the orientation.

3. The method according to claim 2, **characterized in that** producing the bounding box (202, 204, 208, 212, 214) comprises determining a box center of the bounding box (202, 204, 208, 212, 214) depending on the description of the position and determining a box orientation of the bounding box (202, 204, 208, 212, 214) depending on the description of the orientation.

4. The method according to claim 3, **characterized in that** determining the description of the position and the description of the orientation comprises providing a canonical coordinate system representing the scene in a two-dimensional perspective, partitioning the canonical coordinate system into a grid comprising rectangular patches, selecting one patch of the patches and generating the textual description of the position and the orientation depending on the position of the patch in the grid.

5. The method according to one of the claims 2 to 4, **characterized in that** assembling (1206) the scene (300) depending on the layout (200) comprises retrieving a three-dimensional model of the at least one object (502, 504, 508, 512, 514) from a database that comprises three-dimensional models of objects, in particular retrieving the three-dimensional model that has the least Euclidean distance between the dimensions of the three-dimensional model and the bounding box dimensions of the bounding box (202, 204, 208, 212, 214) for the at least one object (502, 504, 508, 512, 514), and placing the retrieved three-dimensional model of the at least one object (502, 504, 508, 512, 514) in the scene (300) at the box center and in the box orientation.

6. The method according to one of the claims 2 to 5, **characterized in that** determining the synthetic digital image (800, 900, 1100) comprises determining the pixel values of pixels in the synthetic digital image (800, 900, 1100) that represent the at least one object (502, 504, 508, 512, 514) with the stable diffusion depending on pixel values of pixels in the digital image that represent the at least one object (502, 504, 508, 512, 514), and setting the pixel values of pixels of the synthetic digital image not representing the at least one object (502, 504, 508, 512, 514) to the values of the pixels of the digital image not representing the at least one object (502, 504, 508, 512, 514).

7. The method according to one of the claims 2 to 6, **characterized in that** the method comprises training the three-dimensional Gaussian Splatting representation (400) and/or the stable diffusion depending on a loss that depends on the values of the pixels representing the at least one object (502, 504, 508, 512, 514).

8. The method according to claim 6 or 7, **characterized in that** the method comprises determining a binary mask indicating whether a pixel represents the at least one object (502, 504, 508, 512, 514) or not, and determining the pixel values of pixels that that represent the at least one object according to the binary mask with the stable diffusion.

9. The method according to one of the preceding claims, **characterized in that** the method comprises generating another synthetic digital image (800, 900, 1000) for the dataset with the stable diffusion depending on the same three-dimensional Gaussian Splatting representation (400).

10. The method according to one of the preceding claims, **characterized in that** the method comprises providing (1202) another at least one text prompt (106), determining (1204, 1206, 1208) another three-dimensional Gaussian Splatting representation (400) depending on the description of the three-dimensional layout of the scene (300, 1100) in the other at least one text prompt (106), and determining (1210) another synthetic digital image (800, 900, 1000) for the dataset depending on the other Gaussian Splatting representation (400) and the description of the style in the other at least one text prompt (106).

11. The method according to one of the preceding claims, **characterized in that** rendering (1210) the digital image (800, 900, 1000) from the three-dimensional Gaussian Splatting representation (400) comprises providing a viewpoint, and rendering a view of the scene (300, 1100) from the viewpoint.

12. The method according to claim 11, **characterized in that** the method comprises providing three different viewpoints, and determining for the three viewpoints, the synthetic digital image (800, 900, 1000) showing the scene (300, 1100) from the respective viewpoint.

13. A device (100) for generating a synthetic digital image (800, 900, 1000) of a three-dimensional scene (1100), in particular for a dataset for training and/or testing of a machine learning system, **characterized in that** the device (100) comprises at least one processor (110) and at least one memory (112) that stores instructions, wherein the at least one processor (110) is configured to execute the instruction that, when executed by the at least processor (110), cause the device (100) to execute the method according to one of the claims 1 to 12.

14. A computer program for generating a synthetic digital image of a three-dimensional scene, in particular for a dataset for training and/or testing of a machine learning system, **characterized in that** the computer program comprises computer executable instructions that, when executed by the computer, cause the computer to execute the method according to one of the claims 1 to 12.

**Amended claims in accordance with Rule 137(2) EPC.**

1. Computer implemented method for generating a synthetic digital image (800, 900, 1000) of a three-dimensional scene (1100), in particular for a dataset for training and/or testing of a machine learning system, wherein the method comprises providing (1202) at least one text prompt (106), wherein the at least one text prompt (106) comprises a description of a three-dimensional layout (200) of the scene (300, 1100), wherein the at least one text prompt (106) comprises a description of a style of the scene (1100), generating (1204) the layout (200) depending on the description of the layout, assembling (1206) the scene (300) depending on the layout (200), determining (1208) a three-dimensional Gaussian Splatting representation (400) of the assembled scene (300) depending on the assembled scene (300), rendering (1210) a digital image (500, 600, 700) from the three-dimensional Gaussian Splatting representation (400), and determining (1212) the synthetic digital image (800, 900, 1000) with a stable diffusion depending on the digital image (500, 600, 700) and the description of the style, wherein the at least one text prompt (106) comprises a description of a position of at least one object (502, 504, 508, 512, 514) in the scene (300, **1100**) in a two-dimensional perspective, and in that the at least one text prompt (106) comprises a description of an orientation of the at least one object (502, 504, 508, 512, 514) in the scene (300, **1100**) in a two-dimensional perspective, wherein generating (1204) the layout (200) comprises producing a three-dimensional bounding box (202, 204, 208, 212, 214) for the at least one object (502, 504, 508, 512, 514) in the scene (300, 1100) depending on the description of the position and the description of the orientation, **characterized in that** determining the synthetic digital image (800, 900, **1100**) comprises determining the pixel values of pixels in the synthetic digital image (800, 900, **1100**) that represent the at least one object (502, 504, 508, 512, 514) with the stable diffusion depending on pixel values of pixels in the digital image that represent the at least one object (502, 504, 508, 512, 514), and setting the pixel values of pixels of the synthetic digital image not representing the at least one object (502, 504, 508, 512, 514) to the values of the pixels of the digital image not representing the at least one object (502, 504, 508, 512, 514).

2. The method according to claim 1, **characterized in that** producing the bounding box (202, 204, 208, 212, 214) comprises determining a box center of the bounding box (202, 204, 208, 212, 214) depending on the description of the position and determining a box orientation of the bounding box (202, 204, 208, 212, 214) depending on the description of the orientation.

3. The method according to claim 2, **characterized in that** determining the description of the position and the description of the orientation comprises providing a canonical coordinate system representing the scene in a two-dimensional perspective, partitioning the canonical coordinate system into a grid comprising rectangular patches, selecting one patch of the patches and generating the textual description of the position and the orientation depending on the position of the patch in the grid.

4. The method according to one of the claims 1 to 3, **characterized in that** assembling (1206) the scene (300) depending on the layout (200) comprises retrieving a three-dimensional model of the at least one object (502, 504, 508, 512, 514) from a database that comprises three-dimensional models of objects, in particular retrieving the three-dimensional model that has the least Euclidean distance between the dimensions of the three-dimensional model and the bounding box dimensions of the bounding box (202, 204, 208, 212, 214) for the at least one object (502, 504, 508, 512, 514), and placing the retrieved three-dimensional model of the at least one object (502, 504, 508, 512, 514) in the scene (300) at the box center and in the box orientation.

5. The method according to one of the claims 1 to 4, **characterized in that** the method comprises training the three-dimensional Gaussian Splatting representation (400) and/or the stable diffusion depending on a loss that depends on the values of the pixels representing the at least one object (502, 504, 508, 512, 514).

6. The method according to claim 1 to 5, **characterized in that** the method comprises determining a binary mask indicating whether a pixel represents the at least one object (502, 504, 508, 512, 514) or not, and determining the pixel values of pixels that that represent the at least one object according to the binary mask with the stable diffusion.

7. The method according to one of the preceding claims, **characterized in that** the method comprises generating another synthetic digital image (800, 900, 1000) for the dataset with the stable diffusion depending on the same three-dimensional Gaussian Splatting representation (400).

8. The method according to one of the preceding claims, **characterized in that** the method comprises providing (1202) another at least one text prompt (106), determining (1204, 1206, 1208) another three-dimensional Gaussian Splatting representation (400) depending on the description of the three-dimensional layout of the scene (300, 1100) in the other at least one text prompt (106), and determining (1210) another synthetic digital image (800, 900, 1000) for the dataset depending on the other Gaussian Splatting representation (400) and the description of the style in the other at least one text prompt (106).

9. The method according to one of the preceding claims, **characterized in that** rendering (1210) the digital image (800, 900, 1000) from the three-dimensional Gaussian Splatting representation (400) comprises providing a viewpoint, and rendering a view of the scene (300, 1100) from the viewpoint.

10. The method according to claim 9, **characterized in that** the method comprises providing three different viewpoints, and determining for the three viewpoints, the synthetic digital image (800, 900, 1000) showing the scene (300, 1100) from the respective viewpoint.

11. A device (100) for generating a synthetic digital image (800, 900, 1000) of a three-dimensional scene (1100), in particular for a dataset for training and/or testing of a machine learning system, **characterized in that** the device (100) comprises at least one processor (110) and at least one memory (112) that stores instructions, wherein the at least one processor (110) is configured to execute the instruction that, when executed by the at least processor (110), cause the device (100) to execute the method according to one of the claims 1 to 10.

12. A computer program for generating a synthetic digital image of a three-dimensional scene, in particular for a dataset for training and/or testing of a machine learning system, **characterized in that** the computer program comprises computer executable instructions that, when executed by the computer, cause the computer to execute the method according to one of the claims 1 to 10.

Fig. 1

Fig. 2

Fig. 3

400

402    402    402

402                                402

402

402                                402

402    402       402

## Fig. 4

500

512    506    502    508    510

504

516

514

## Fig. 5

Fig. 6

Fig. 7

Fig. 8

Fig. 9

Fig. 10

Fig. 11

Fig. 12

Europäisches
Patentamt

European
Patent Office

Office européen
des brevets

# EUROPEAN SEARCH REPORT

**Application Number**

EP 24 19 0113

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | XIAOYU ZHOU ET AL: "GALA3D: Towards Text-to-3D Complex Scene Generation via Layout-guided Generative Gaussian Splatting", ARXIV.ORG, CORNELL UNIVERSITY LIBRARY, 201 OLIN LIBRARY CORNELL UNIVERSITY ITHACA, NY 14853, 11 June 2024 (2024-06-11), XP091781803, * figures 1,2,4,7 * * section 3, paragraph 1 * * section 3.1 * * sections 3.3 to 3.5 * * section 4.4 * ----- | 1-3,6,7, 10-14 | INV. G06T15/20 G06T17/00 |
| Y | WEIXI FENG ET AL: "LayoutGPT: Compositional Visual Planning and Generation with Large Language Models", ARXIV.ORG, CORNELL UNIVERSITY LIBRARY, 201 OLIN LIBRARY CORNELL UNIVERSITY ITHACA, NY 14853, 28 October 2023 (2023-10-28), XP091647185, * figures 1,2,3,6,7,13,18; table 1 * * section 3 * * section 5, subsection 5.1, first paragraph * * section 5.3, paragraph 1 * * section B.1, page 16 * * section C, paragraph 1 * ----- -/-- | 1-14 | |

|  |  |
|---|---|
|  | **TECHNICAL FIELDS SEARCHED (IPC)** |
|  | G06T |

The present search report has been drawn up for all claims

| Place of search | Date of completion of the search | Examiner |
|---|---|---|
| Berlin | 12 December 2024 | Gauthier, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 24 19 0113

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | Vachha Cyrus ET AL: "Instruct-GS2GS: Editing 3D Gaussian Splats with Instructions", https://instruct-gs2gs.github.io/, 14 March 2024 (2024-03-14), pages 1-6, XP093232630, Retrieved from the Internet: URL:https://web.archive.org/web/20240314134553if_/https://instruct-gs2gs.github.io/data/Instruct-GS2GS_2024.pdf [retrieved on 2024-12-10] * figures 1,2,3,5 * * section 2, subsections "Generating 3D content" and "Instruction as an editing interface" * * section 3, paragraph 1 * * section 3.1, subsections "Gaussian splatting" and "intructPix2Pix" * * section 3.2, subsection "editing a rendered image" * ----- | 1-14 | |
| A | DESPOINA PASCHALIDOU ET AL: "ATISS: Autoregressive Transformers for Indoor Scene Synthesis", ARXIV.ORG, CORNELL UNIVERSITY LIBRARY, 201 OLIN LIBRARY CORNELL UNIVERSITY ITHACA, NY 14853, 7 October 2021 (2021-10-07), XP091073519, * section 3.3, last paragraph, last two sentences * ----- | 5 | **TECHNICAL FIELDS SEARCHED (IPC)** |
| T | ÖCAL ET AL: "SceneTeller: Language-to-3D Scene Generation", ARXIV.ORG, CORNELL UNIVERSITY LIBRARY, 201 OLIN LIBRARY CORNELL UNIVERSITY ITHACA, NY 14853, 30 July 2024 (2024-07-30), XP091835075, * the whole document * ----- | | |

The present search report has been drawn up for all claims

| Place of search | Date of completion of the search | Examiner |
|---|---|---|
| Berlin | 12 December 2024 | Gauthier, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................

& : member of the same patent family, corresponding document

EPO FORM 1503 03.82 (P04C01)

page 2 of 2